**Europäisches Patentamt**

**European Patent Office**

**Office européen des brevets**

(19)

(11) Veröffentlichungsnummer: **0 019 774**
**B1**

(12) # EUROPÄISCHE PATENTSCHRIFT

(45) Veröffentlichungstag der Patentschrift:
**19.10.83**

(51) Int. Cl.³: **G 06 F 11/16**

(21) Anmeldenummer: **80102543.8**

(22) Anmeldetag: **08.05.80**

(54) **Verfahren und Schaltungsanordnung zur Bereitstellung von logischen Verknüpfungsergebnissen in datenverarbeitenden Einrichtungen.**

(30) Priorität: **31.05.79 DE 2922234**

(43) Veröffentlichungstag der Anmeldung:
**10.12.80 Patentblatt 80/25**

(45) Bekanntmachung des Hinweises auf die Patenterteilung:
**19.10.83 Patentblatt 83/42**

(84) Benannte Vertragsstaaten:
**AT BE CH FR GB IT LI LU NL SE**

(56) Entgegenhaltungen:
**FR-A-2 097 416**
**FR-A-2 144 902**
**PROCEEDINGS OF THE FALL JOINT COMPUTER CONFERENCE, Las Vegas, Nevada, 18.—20. November 1969 A. F. I. P. S. Conference proceedings, Band 35, MONTREALE N.J. (US), E. J. DIETERICH et al.: »A compatible airborne multiprocessor«, Seiten 347—357**
**AMERIKANISCHER BERICHT, AD 698496, herausgegeben durch den »US Department of Commerce/National Bureau of Standards«, Juni 1969 BIERMAN: »Built-in self-test for an airborne digital computer« Seiten 46—94**

(73) Patentinhaber: **SIEMENS AKTIENGESELLSCHAFT, Berlin und München Wittelsbacherplatz 2, D-8000 München 2 (DE)**

(72) Erfinder: **Stadlmeier, Hans, Dipl.-Ing., Aichacherstrasse 2, D-8000 München 70 (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Verfahren und Schaltungsanordnung zur Bereitstellung von logischen
Verknüpfungsergebnissen in datenverarbeitenden Einrichtungen

Die Erfindung betrifft ein Verfahren und eine Schaltungsanordnung zur Bereitstellung von logischen Verknüpfungsergebnissen in datenverarbeitenden Einrichtungen, wobei die Verknüpfungsergebnisse jeweils aus wenigstens zum Teil von zusätzlichen Entscheidungsvariablen abhängigen Eingangsgrößen ermittelt werden, indem vorsorglich alle möglichen Verknüpfungsergebnisse durch getrennte Einrichtungen gleichzeitig ermittelt werden, von denen nach Vorliegen der Entscheidungsvariablen das zutreffende Verknüpfungsergebnis ausgewählt und für die weitere Verarbeitung freigegeben wird.

Bei der Ableitung von logischen Verknüpfungsergebnissen in datenverarbeitenden Einrichtungen besteht häufig die Notwendigkeit, ein bereits vorliegendes erstes Ergebnis aufgrund einer erst später sich ergebenden Entscheidungsvariablen durch ein zweites Ergebnis zu ersetzen und dieses für die weitere Verarbeitung freizugeben. Dabei bestehen zwei Möglichkeiten. Bei der einen Möglichkeit wird zunächst das eine Ergebnis ermittelt und, falls die später eintreffende Entscheidungsvariable keine Änderung erzwingt, freigegeben. Andernfalls, bedingt durch die Entscheidungsvariable, wird das zweite Ergebnis ermittelt und freigegeben. Bei der anderen Möglichkeit werden vorsorglich beide Ergebnisse zeitlich parallel ermittelt und dann abhängig von der Entscheidungsvariablen das benötigte Ergebnis ausgewählt und freigegeben. Der schaltungstechnische Aufwand vergrößert sich dadurch zwangsläufig, wenn auch Zeit eingespart werden kann.

Unabhängig davon erfordern komplexe logische Schaltungen zusätzliche Sicherungsmaßnahmen gegen Fehler und Ausfall. Derartige Maßnahmen bestehen häufig in einer Verdoppelung der Anordnungen, die zeitlich parallel arbeiten und deren Ergebnisse durch Vergleicher überwacht werden. Die Anwendung dieser Maßnahme auf Einrichtungen der vorgenannten Art würde den Aufwand, insbesondere bei der nach der zweiten Möglichkeit arbeitenden Anordnung, wesentlich vergrößern.

Aufgabe der Erfindung ist es daher, ein Verfahren der eingangs genannten Art sowie eine nach diesem Verfahren arbeitende Schaltungsanordnung zu schaffen, das bzw. die trotz gleichzeitiger Sicherung der Arbeitsweise einen geringeren Aufwand erfordert.

Diese Aufgabe wird bei dem neuen Verfahren gemäß der Erfindung dadurch gelöst, daß zur Sicherung des jeweils bereitgestellten Verknüpfungsergebnisses alle das (bzw. die) nach Vorliegen der Entscheidungsvariablen nicht benötigte(n) Verknüpfungsergebnis(se) liefernden Einrichtungen umgeschaltet und das benötigte Verknüpfungsergebnis durch diese Einrichtungen erneut ermittelt wird, daß danach alle vorhandenen Verknüpfungsergebnisse miteinander verglichen werden und daß bei deren mehrheitlicher Nichtübereinstimmung die weitere Verarbeitung gestoppt wird.

Wie bei der bekannten Lösung ohne Sicherung wird nur ein Satz von Einrichtungen zur Ermittlung der Verknüpfungsergebnisse benötigt und wie bisher alle möglichen Verknüpfungsergebnisse vorsorglich ermittelt. Durch die anschließende Änderung der abhängigen Größen am Eingang der betroffenen Einrichtungen nach Vorliegen der Entscheidungsvariablen wird dann das benötigte Verknüpfungsergebnis auf parallelem Wege erneut ermittelt und damit eine Vergleichsmöglichkeit geschaffen, die in bekannter Weise eine Sicherung ermöglicht, ohne daß das Prinzip der Auswahl zwischen den möglichen Verknüpfungsergebnissen mit seinen Vorteilen verlassen wird. Letzteres gilt insbesondere, wenn gemäß einer Weiterbildung der Erfindung bei Übereinstimmung jeweils das zuerst ermittelte benötigte Verknüpfungsergebnis für die weitere Verarbeitung freigegeben wird.

Um eindeutige Ergebnisse zu erhalten, laufen die einzelnen Phasen des Ermittlungs- und Überwachungsvorganges taktgesteuert ab.

Eine Schaltungsanordnung zur Durchführung des neuen Verfahrens gemäß der Erfindung ist gekennzeichnet durch zwei Verknüpfungseinrichtungen zur Ermittlung von logischen Verknüpfungsergebnissen aus einer Basisgröße und jeweils einer von zwei weiteren Größen abhängig von einer Entscheidungsvariablen, durch einen mit den Ausgängen der beiden Verknüpfungseinrichtungen verbundenen Auswahlschalter zur Weiterleitung des von der Entscheidungsvariablen abhängigen zutreffenden Verknüpfungsergebnisses, durch jeweils einen durch von der Entscheidungsvariablen abgeleitete Steuersignale beeinflußbaren Auswahlschalter am Eingang für die auswählbare Größe jeder Verknüpfungseinrichtung, durch eine Einrichtung zur Erzeugung der Steuersignale für die Auswahlschalter in der Weise, daß in einem ersten Schritt jede Verknüpfungseinrichtung jeweils eine andere der auswählbaren Größen verarbeitet und daß in einem zweiten Schritt nach Vorliegen der Entscheidungsvariablen bei allen betroffenen Verknüpfungseinrichtungen auf die durch die Entscheidungsvariable bestimmte auswählbare Größe umgeschaltet wird, und durch einen mit den Ausgängen beider Verknüpfungseinrichtungen verbundenen Vergleicher.

Der Aufwand für eine derartige Schaltungsanordnung ist also nicht größer als der einer synchron arbeitenden, gedoppelten Anordnung mit vorsorglicher Ermittlung nur eines der beiden möglichen Verknüpfungsergebnisse auf parallelem Wege. Bei der neuen Anordnung werden jedoch die Auswahlschalter am Eingang der Verknüpfungseinrichtung durch die Entscheidungsvariable unterschiedlich, z. B. entgegengesetzt, beeinflußt, so daß beide möglichen Verknüpfungsergebnisse gleichzeitig zur Verfügung stehen und unmittelbar mit Vorliegen der Entscheidungsvariablen eine Auswahl getroffen werden kann.

Dabei ist es zweckmäßig, zusätzlich eine Einrichtung zur Erzeugung der Steuersignale für den Auswahlschalter am Ausgang der Verknüpfungseinrichtung vorzusehen, die jeweils die Bereitstellung des im ersten Schritt bereits ermittelten zutreffenden Verknüpfungsergebnisses bedingt.

Die Steuerung der Anordnung gestaltet sich zudem besonders einfach, wenn die Einrichtungen zur Erzeugung der Steuersignale für die Auswahlschalter aus zwei Steuergattern bestehen, die die Entscheidungsvariable einmal direkt und einmal als invertiertes Signal während eines die Überwachungsphase bestimmenden Impulses freigeben.

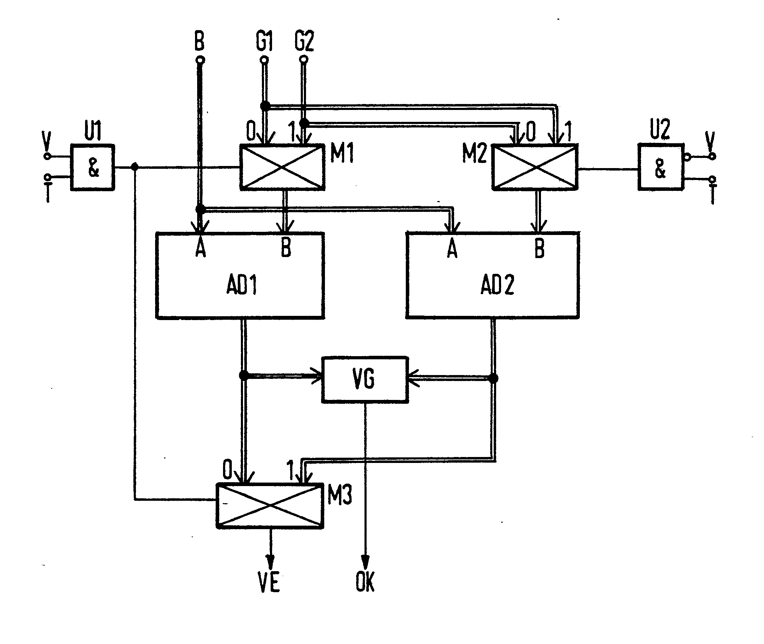

Im folgenden wird die Erfindung anhand eines in der Zeichnung dargestellten Ausführungsbeispieles näher erläutert, das sich auf die Adressenrechnung in datenverarbeitenden Einrichtungen bezieht.

Gezeigt sind daher zwei Addierer AD1 und AD2, die als logische Einrichtungen aus jeweils zwei Eingangsgrößen, z. B. B und G1 bzw. B und G2, das jeweils benötigte Verknüpfungsergebnis VE ermitteln. Die Eingangsgröße B stellt als Basisgröße eine Anfangsadresse oder eine laufende Adresse für einen nicht gezeigten Speicher dar, die abhängig von der Eingangsgröße G1 durch Addition einer 1 oder einer 2 erhöht wird oder aber abhängig von der Eingangsgröße G2 in Form einer Distanzadresse sprunghaft geändert wird.

Die Entscheidung darüber, welche der Größen G1 und G2 am Eingang B der Addierer zu verwenden ist, trifft die Entscheidungsvariable V, die in an sich bekannter Weise von einer nicht dargestellten Bedingungskontrolle geliefert wird, in Verbindung mit den Auswahlschaltern M1 und M2, die über UND-Glieder U1 bzw. U2 entgegengesetzt beeinflußbar sind. Auf diese Weise ist am Addierer AD1 normalerweise die Größe G1 und am Addierer AD2 normalerweise die Größe G2 wirksam, so daß beide möglichen Verknüpfungsergebnisse an den Ausgängen der beiden Addierer zur Verfügung stehen. Diese Ausgänge sind in bekannter Weise mit einem Vergleicher VG zur Sicherung und mit einem weiteren Auswahlschalter M3, der ebenfalls von der Entscheidungsvariablen V beeinflußbar ist, verbunden.

Beim Fehlen der Entscheidungsvariablen V oder bei einer die Eingangsgröße G1 erfordernden Entscheidungsvariablen V liefert der Ausgang des Auswahlschalters M3 das Ergebnis der Einrichtung AD1 als Verknüpfungsergebnis VE. Beinhaltet die Entscheidungsvariable V jedoch eine Umschaltung auf die Eingangsgröße G2, so wird die Umschaltung sofort mit Takt T wirksam, und der Auswahlschalter M3 liefert das Ergebnis der Einrichtung AD2.

Zeitlich parallel dazu wird mit Takt T über eines der UND-Glieder U1 oder U2 der jeweils nachgeschaltete Auswahlschalter M1 bzw. M2 umgeschaltet, und zwar der Auswahlschalter M2, wenn die Eingangsgröße G1 benötigt wird oder der Auswahlschalter M1, wenn die Eingangsgröße G2 benötigt wird. Das hat zur Folge, daß das von der einen Einrichtung, z. B. AD1, bereits ermittelte Verknüpfungsergebnis von der anderen Einrichtung, z. B. AD2, nochmals ermittelt wird, und damit beide Einrichtungen AD1 und AD2 bei fehlerfreier Arbeit dasselbe Ergebnis liefern, so daß eine Sicherungsüberwachung durch den Vergleicher VG möglich ist.

Bei übereinstimmenden Ergebnissen liefert der Vergleicher VG ein Steuersignal ok, das in an sich bekannter Weise die weitere Verarbeitung mit dem am Ausgang des Auswahlschalters M3 bereits zur Verfügung gestellten Verknüpfungsergebnis VE freigibt. Andernfalls wird der laufende Verarbeitungsvorgang gestoppt und in an sich bekannter Weise eine Wiederholung oder eine andere übliche Sicherheitsroutine ausgelöst.

Durch den Takt T wird in einfacher Weise eine Aufteilung der Arbeitsweise der Anordnung in zwei Phasen bewirkt, nämlich in die Phase der vorsorglichen Ermittlung beider Verknüpfungsergebnisse und in die Phase der Auswahl durch den Auswahlschalter M3 mit Überwachung durch den Vergleicher VG, so daß das tatsächlich benötigte Verknüpfungsergebnis VE abhängig vom Takt T eindeutig identifizierbar ist. Weiterhin könnte der Vergleicher VG, ausgehend vom Takt T mit einer die Arbeitszeit der Addierer AD . . . berücksichtigenden Verzögerung ebenfalls getaktet werden, so daß die Auswertung der Ausgangssteuersignale des Vergleichers VG zeitlich festgelegt ist. Als Takte können dabei ganz allgemein Takte der zugehörigen datenverarbeitenden Einrichtung, die im übrigen nicht gezeigt ist, verwendet werden.

Die gezeigten Bauteile können in jeder dem Fachmann bekannten Weise ausgebildet und den jeweiligen Bedingungen angepaßt sein. In Abwandlung des gezeigten Ausführungsbeispieles kann an Stelle der Basisgröße B auch eine durch einen weiteren Auswahlschalter auswählbare Eingangsgröße verwendet werden, ohne daß das der Erfindung zu Grunde liegende Lösungsprinzip dadurch verlassen wird.

## Patentansprüche

1. Verfahren zur Bereitstellung von logischen Verknüpfungsergebnissen in datenverarbeitenden Einrichtungen, wobei die Verknüpfungsergebnisse jeweils aus wenigstens zum Teil von zusätzlichen Entscheidungsvariablen abhängigen Eingangsgrößen ermittelt werden, indem vorsorglich alle möglichen Verknüpfungsergebnisse durch getrennte Einrichtungen gleichzeitig ermittelt werden, von denen nach Vorliegen der Entscheidungsvariablen das zutreffende Verknüpfungsergebnis ausgewählt und für die weitere Verarbeitung freigegeben wird, dadurch gekennzeichnet, daß zur Sicherung des jeweils bereitgestellten Verknüpfungsergebnisses alle das (bzw. die) nach Vorliegen der Entscheidungsvariablen nicht benötigte(n) Verknüpfungsergebnis(se) liefernden Einrichtungen (z. B. AD1) umgeschaltet werden und das benötigte Verknüpfungsergebnis durch diese Einrichtungen erneut ermittelt wird, daß danach alle vorhandenen Verknüpfungsergebnisse miteinander verglichen werden und daß bei mehrheitlicher Nichtübereinstimmung die weitere Verarbeitung des ausgewählten Verknüpfungsergebnisses (VE) gestoppt wird.

2. Verfahren nach Anspruch 1, dadurch gekennzeichnet, daß bei Übereinstimmung jeweils das zuerst ermittelte benötigte Verknüpfungsergebnis für die weitere Verarbeitung freigegeben wird.

3. Verfahren nach Anspruch 1 oder 2, dadurch gekennzeichnet, daß die einzelnen Phasen des Ermittlungs- und Überwachungsvorganges taktgesteuert ablaufen.

4. Schaltungsanordnung zur Durchführung des Verfahrens nach einem der Ansprüche 1 bis 3, gekennzeichnet
durch zwei Verknüpfungseinrichtungen (z. B. Addierer AD1 und AD2) zur Ermittlung von logischen Verknüpfungsergebnissen (VE, z. B. Folgeadressen für einen Befehlsspeicher) aus einer Basisgröße (B, z. B. jeweils letzte Ansteueradresse des Befehlsspeichers) und jeweils einer von zwei weiteren Größen (G1 bzw. G2, z. B. Ziff. 1 oder Distanzadresse) abhängig von einer Entscheidungsvariablen (V, z. B. Sprung),
durch einen mit den Ausgängen der beiden Verknüpfungseinrichtungen (AD1, AD2) verbundenen Auswahlschalter (M3) zur Weiterleitung des von der Entscheidungsvariablen (V) abhängigen zutreffenden Verknüpfungsergebnisses (VE), durch jeweils einen durch von der Entscheidungsvariablen (V) abgeleitete Steuersignale (am Ausgang der Steuergatter U1 und U2) beeinflußbaren Auswahlschalter (M1 bzw. M2) am Eingang für die auswählbare Größe (G1 bzw. G2) jeder Verknüpfungseinrichtung (AD1, AD2),
durch eine Einrichtung (U1, U2) zur Erzeugung der Steuersignale für die Auswahlschalter (M1, M2) in der Weise, daß in einem ersten Schritt jede Verknüpfungseinrichtung (AD1, AD2) jeweils eine andere der auswählbaren Größen (G1 bzw. G2) verarbeitet und daß in einem zweiten Schritt nach Vorliegen der Entscheidungsvariablen (V) bei allen betroffenen Verknüpfungseinrichtungen (z. B. AD2) auf die durch die Entscheidungsvariable (V) bestimmte auswählbare Größe (z. B. G1) umgeschaltet wird, und durch einen mit den Ausgängen beider Verknüpfungseinrichtungen (AD1 und AD2) verbundenen Vergleicher (VG).

5. Schaltungsanordnung nach Anspruch 4, gekennzeichnet durch eine Einrichtung zur Erzeugung der Steuersignale für den Auswahlschalter (M3) am Ausgang der Verknüpfungseinrichtung (AD1, AD2), die jeweils die Bereitstellung des im ersten Schritt bereits ermittelten zutreffenden Verknüpfungsergebnisses (VE) bedingt.

6. Schaltungsanordnung nach Anspruch 4 oder 5, dadurch gekennzeichnet, daß die Einrichtungen zur Erzeugung der Steuersignale für die Auswahlschalter (M1, M2, M3) aus zwei Steuergattern (U1, U2) bestehen, die die Entscheidungsvariable (V) einmal direkt und einmal als invertiertes Signal während eines die Überwachungsphase bestimmenden Impulses (T=1) freigeben.

**Claims**

1. Method for the preparation of logic linking results in data processing devices, wherein the logic linking results are each determined from input values which at least partially depend upon additional decision variables in that by way of precaution all the possible logic linking results are determined simultaneously by separate devices from which — following the occurrence of the decision variables — the pertinent logic linking result is selected and is released for further processing, characterised in that in order to safeguard the prepared logic linking result, all those devices (e. g. AD1) which supply the logic linking result(s) which is/are unrequired following the occurrence of the decision variables are switched over and the required logic linking result is redetermined by these devices, that subsequently all the available logic linking results are compared with one another, and that if for the main part these are non-identical the further processing of the selected logic linking result (VE) is stopped.

2. Method as claimed in claim 1, characterised in that in the case of identity, the first required logic linking result to have been determined is released for further processing.

3. Method as claimed in claim 1 or 2, characterised in that the individual phases of the determining and monitoring procedure are carried out under the control of clock pulses.

4. Circuit arrangement for the implementation of the method claimed in one of the claims 1 to 3, characterised
by two logic linking devices (e. g. adders AD1 and AD2) which serve to determine logic linking results (VE, e. g. sequence addresses for a command store) from a base value (B, e. g. the last drive address of the command store) and from one of two further values (G1 and G2, e. g. digit 1 or distance address) in dependence upon a decision variable (V, e. g. jump),
further characterised by a selection switch (M3) which is connected to the outputs of the two logic linking devices (AD1, AD2) and which serves to forward the pertinent logic linking result (VE) which is dependent upon the decision variable (E), further characterised by a selection switch (M1 and M2) which can be influenced by control signals (at the output of the control gates U1 and U2) derived from the decision variable (E) and which are arranged at the input for the selectable value (G1, G2) of each logic linking device (AD1, AD2),

further characterised by a device (U1, U2) which serves to generate the control signals for the selection switches (M1, M2) in that in a first step each logic linking device (AD1, AD2) processes a respective other of the selectable values (G1, G2), and that in a second step following the occurrence of the decision variable (E) in all the logic linking devices in question (e. g. AD2) a switchover is made to the selectable value (e. g. G1) determined by the decision variable (E), and further characterised by a comparator (VG) which is connected to the outputs of the two logic linking devices (AD1 and AD2).

5. Circuit arrangement as claimed in claim 4, characterised by a device which generates the control signals for the selection switch (MC) at the output of the logic linking device (AD1, AD2) which makes available the relevant logic linking result (VE) which has already been determined in the first step.

6. Circuit arrangement as claimed in claim 4 or 5, characterised in that the devices which generate the control signals for the selection switches (M1, M2, M3) consist of two control gates (U1, U2) which release the decision variable (E) once directly and once as an inverted signal during a pulse (T=1) which determines the monitoring phase.

## Revendications

1. Procédé de préparation de résultats de combinaisons logiques dans des dispositifs de traitement des données, les résultats de combinaisons se calculant chaque fois à partir de grandeurs d'entrées dépendant au moins en partie de variables de décision supplémentaires, tous les résultats possibles de combinaisons étant, par précaution, calculés en même temps par des dispositifs séparés, qui, après avoir disposé de la variable de décision, choisissent le résultat de combinaisons qui convient et autorisent la suite de traitement de ce résultat, caractérisé en ce que, pour la sécurité du résultat de combinaisons chaque fois préparé, tous les dispositifs (par ex. AD1) délivrant le (ou les ) résultat(s) de combinaisons qui n'est (ne sont) pas nécessaire(s) après la présence de la variable de décision, sont commutés et que le résultat de combinaisons nécessaire est de nouveau calculé par ces dispositifs; qu'ensuite tous les résultats de combinaison existants sont comparés entre eux et qu'en cas de discordance majoritaire, la suite du traitement du résultat de combinaisons choisi (VE) est arrêtée.

2. Procédé suivant la revendication 1, caractérisé en ce qu'en cas de concordance, c'est le premier résultat nécessaire de combinaisons calculé qui est autorisé pour la suite du traitement.

3. Procédé suivant une quelconque des revendications 1 ou 2, caractérisé en ce que les différentes phases de l'opération de calcul et de contrôle sont rythmées.

4. Circuit pour l'exécution du procédé suivant une quelconque des revendications 1 à 3, caractérisé par deux dispositifs de combinaisons (par ex. les additionneurs AD1 et AD2), pour le calcul de résultats de combinaisons logiques (VE, par ex. adresses de séquences pour une mémoire d'ordres) à partir d'une grandeur de base (B, parex. chaque fois la dernière adresse d'attaque de la mémoire d'ordres) et de l'une de deux autres grandeurs (G1 ou G2, par ex. repère 1 ou adresse de décalage) en fonction d'une variable de décision (V, par ex. un saut); par un sélecteur (M3) relié aux sorties des deux dispositifs de combinaisons (AD1, AD2) et destiné à transmettre le résultat de combinaisons VE adéquat dépendant de la variable de décision (V); par un sélecteur (M1 ou M2) placé sous l'action de signaux de commande (à la sortie des portes de commande U1 et U2) dérivés de la variable de décision (V), ce sélecteur étant placé à l'entrée pour la grandeur à choisir (G1 ou G2) de chaque dispositif de combinaison (AD1, AD2); par un dispositif (U1, U2) produisant les signaux de commande pour les sélecteurs (M1, M2), de manière que, dans une première phase, chaque dispositif de combinaisons (AD1, AD2) traite chaque fois une grandeur à choisir (G1 ou G2) différente et que, dans une deuxième phase, en présence de la variable de décision (V), il se produise, pour tous les dispositifs de combinaisons concernés (par ex. AD2), une commutation sur la grandeur à choisir (par ex. G1), qui est fixée par la variable de décision (V), ainsi que par un comparatuer (VG) relié aux sorties des deux dispositifs de combinaison (AD1 et AD2).

5. Circuit suivant la revendication 4, caractérisé par un dispositif produisant les signaux de commande pour le sélecteur (M3) placé à la sortie du dispositif de combinaisons (AD1, AD2), qui conditionne chaque fois la préparation du résultat de combinaisons (VE) adéquat, déjà calculé dans la première phase.

6. Circuit suivant une quelconque des revendications 4 et 5, caractérisé en ce que les dispositifs produisant les signaux de commande pour les sélecteurs (M1, M2, M3) sont composés de deux portes de commande (U1, U2), qui autorisent la variable de décision (V) une fois directement et une fois sous forme de signal inverti, pendant une impulsion (T=1) déterminant la phase de contrôle.